# EUROPÄISCHE PATENTSCHRIFT

(11) **EP 1 652 414 B1**
(45) Veröffentlichungstag und Bekanntmachung des Hinweises auf die Patenterteilung: **05.09.2007**
(21) Anmeldenummer: 04763061.1
(22) Anmeldetag: 01.07.2004
(51) Int. Cl.: H05K 3/36, H01R 12/32

(54) **ABSTÜTZELEMENT FÜR EINE AUF EINER ERSTEN LEITERPLATTE A NGEORDNETE ZWEITE LEITERPLATTE**
SUPPORT ELEMENT FOR A SECOND PRINTED CIRCUIT BOARD ARRANGED ON A FIRST CIRCUIT BOARD
ELEMENT SUPPORT POUR UNE DEUXIEME CARTE A CIRCUITS IMPRIMES PLACEE SUR UNE PREMIERE CARTE A CIRCUITS IMPRIMES

(30) Priorität: 04.08.2003 AT 12332003
(43) Veröffentlichungstag der Anmeldung: 03.05.2006
(73) Patentinhaber: Siemens AG Österreich, 1210 Wien (AT)
(72) Erfinder: ROTHMAYER, Thomas, A-1180 Wien (AT)
(74) Vertreter: Peham, Alois
(86) Internationale Anmeldenummer: PCT/EP2004/007133
(87) Internationale Veröffentlichungsnummer: WO 2005/020652

(56) Entgegenhaltungen:
- DE-A- 19 842 237
- DE-B- 1 257 235
- FR-A- 2 693 340

## Beschreibung

Die Erfindung betrifft ein Abstützelement für eine auf einer ersten Leiterplatte angeordnete zweite Leiterplatte, wobei das Abstützelement eine schlitzförmige Aufnahme für die zweite Leiterplatte und zumindest zwei Befestigungsfortsätze aufweist, die zur Befestigung an der ersten Leiterplatte vorgesehen sind und wobei die schlitzförmige Aufnahme von zwei Stegen mit je einem freien Enden begrenzt ist, den freien Enden gegenüberliegende Abschnitte der Stege über den Grund der Aufnahme miteinander verbunden und voneinander beabstandet sind.

Weiters betrifft die Erfindung ein elektronisches Gerät mit zumindest zwei Leiterplatten deren Leiterplattenebenen unter einem Winkel von im wesentlichen 90° zu einander verlaufen.

Das Verlöten von Subleiterplatten mit Grundleiterplatten im Rahmen der Herstellung von elektronischen Geräten ist üblicherweise sehr aufwendig, da die Subleiterplatten beim Löten gestützt werden müssen. Darüber hinaus weisen derartig miteinander verbundene Leiterplatten nur eine geringe mechanische Stabilität auf.

Zur Stützung der Subleiterplatten und zur Erhöhung der mechanischen Stabilität kommen für gewöhnlich aufwendige Schraubverbindungen zum Einsatz. Diese haben jedoch den Nachteil, dass sie zum einen einen großen fertigungstechnischen Aufwand bei der Herstellung elektronischer Geräte bedeuten und somit die Herstellungskosten in die Höhe treiben, zum anderen mit der Gefahr verbunden sind, während des Verschraubens die Leiterplatte zu beschädigen.

Aus der DE 198 42 237 ist ein Abstützelement der eingangs genannten Art für eine auf einer ersten Leiterplatte angeordnete zweite Leiterplatte bekannt geworden. Das bekannte Abstützelement weist eine schlitzförmige Aufnahme für die zweite Leiterplatte und zumindest zwei Befestigungsfortsätze aufweist, die zur Befestigung an der ersten Leiterplatte vorgesehen sind. Die beiden Stege der schlitzförmigen Aufnahme weisen dabei einen Abstand auf, der im Wesentlichen der Dicke der zweiten Leiterplatte entspricht. Dadurch kann es bei der Montage zur Verklemmung der zweiten Leiterplatte in der schlitzförmigen Aufnahme kommen.

Aus der FR 2 693 340 ist ein Abstützelement mit einer schlitzförmigen Aufnahme für eine Leiterplatte bekannt, wobei dieses Abstützelement mit einem Befestigungsfortsatz oder einer ebenfalls schlitzförmigen Aufnahme auf einer Basisleiterplatte montierbar ist. Die schlitzförmige Aufnahme wird durch zwei Stege begrenzt, wobei ein Steg als parallel zur Leiterplatte verlaufende Auflage ausgebildet ist und der gegenüberliegende Steg sägezahnförmige Ausprägungen aufweist. Mittels dieser sägezahnförmigen Ausprägungen soll die Leiterplatte im montierten Zustand fixiert werden, indem die Spitzen der sägezahnförmigen Ausprägungen gegen die Oberfläche der Leiterplatte drücken.

Beide bekannten Abstützelemente weisen den Nachteil auf, dass Leiterplatten bei der Montage oder einer Demontage im Zuge von Reparaturen oder Erweiterungs- bzw. Umsteckvorgängen durch Abrieb an der Oberfläche beschädigt werden können. Deshalb ist es auch nicht möglich, auf einer Leiterplatte Leiterbahnen in dem Bereich anzuordnen, welcher im montierten Zustand von der Aufnahme eines Abstützelements abgedeckt ist.

Es ist daher eine Aufgabe der Erfindung, den oben genannten Nachteil zu überwinden.

Diese Aufgabe wird mit einem Abstützelement der eingangs erwähnten Art erfindungsgemäß dadurch gelöst, dass die die freien Enden in Richtung einer Längsmittelebene vorspringende Fortsätze aufweisen und dass die freien Stege unterschiedlich lang sind.

In die schlitzförmige Aufnahme kann die zweite Leiterplatte eingeführt werden und so von dem Abstützelement gehalten werden, das Abstützelement kann mit der Grundleiterplatte verlötetet werden. Weiters lässt sich durch das erfindungsgemäße Abstützelement die mechanische Stabilisierung der beiden Leiterplatten erhöhen.

Die mechanische Stabilität bzw. die Befestigung der zweiten Leiterplatte lässt sich dadurch weiter verbessern, dass der Normalabstand zwischen jedem Steg und einer Längsmittelebene der Aufnahme im Wesentlichen der halben Dicke der zweiten Leiterplatte entspricht.

Das Abstützelement weist eine im wesentlichen plattenförmige Basis auf, wobei an den freien Enden der Stege in Richtung der Längsmittelebene der Aufnahme vorspringende Fortsätze vorgesehen sind. Hierbei weisen die freien Stege unterschiedliche Längen auf.

Darüber hinaus kann das Abstützelement zumindest zwei Fortsätze aufweisen, die zur Befestigung an der ersten Leiterplatte vorgesehen sind. Mit diesen Fortsätzen kann das Abstützelement auf der Grundleiterplatte verlötet werden.

In einer Variante der Erfindung kann die Aufnahme einen im Wesentlichen U-förmigen Querschnitt aufweisen.

Weitere Vorteile lassen sich dadurch erzielen, dass das Abstützelement einen an die Aufnahme anschließenden Abschnitt aufweist, durch den die Aufnahme in einem montierten Zustand von der ersten Leiterplatte beabstandet ist.

Die oben genannten Aufgaben lassen sich auch mit einem elektronischen Gerät der eingangs genannten Art erfindungsgemäß dadurch lösen, dass eine der beiden Leiterplatten von einem Abstützelement nach einem der Ansprüche 1 bis 5 gestützt und auf der anderen Leiterplatte gehalten ist, wobei die von dem Abstützelement gestützte Leiterplatte einen Schlitz für den die Aufnahme des Abstützelements von der Grundleiterplatte beabstandenden Abschnitts aufweisen kann.

Die Erfindung samt weiterer Vorteile wird im Folgenden anhand einiger nicht einschränkender Ausführungsbeispiele näher erläutert, welche in der Zeichnung dargestellt sind. In dieser zeigen schematisch:
- Fig.: 1 ein erfindungsgemäßes Abstützelement in einer seitlichen Ansicht;
- Fig. 2: das Abstützelement aus Fig. 1 in einer Draufsicht und
- Fig. 3: ein erfindungsgemäßes elektronisches Gerät in einer perspektivischen Ansicht.

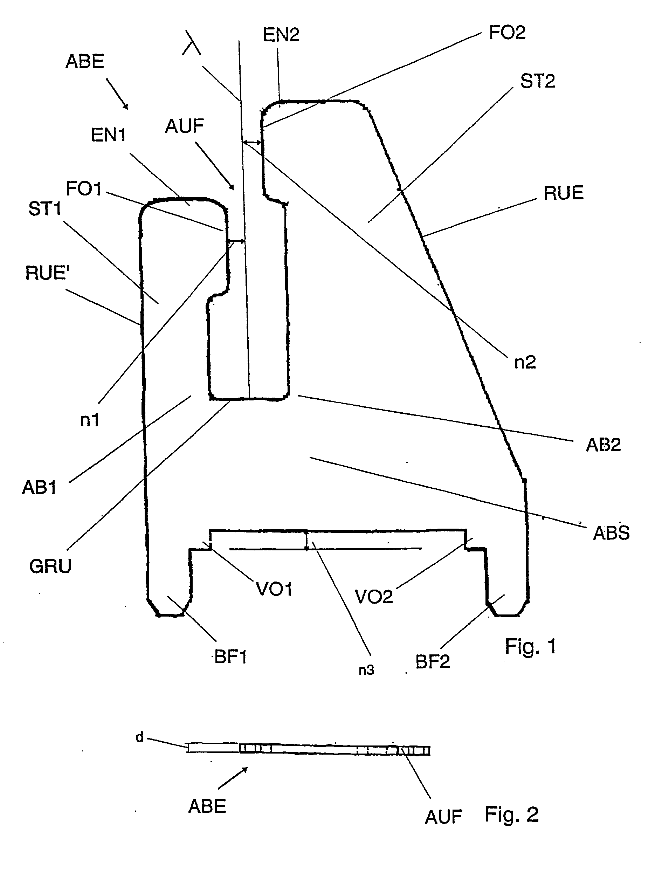

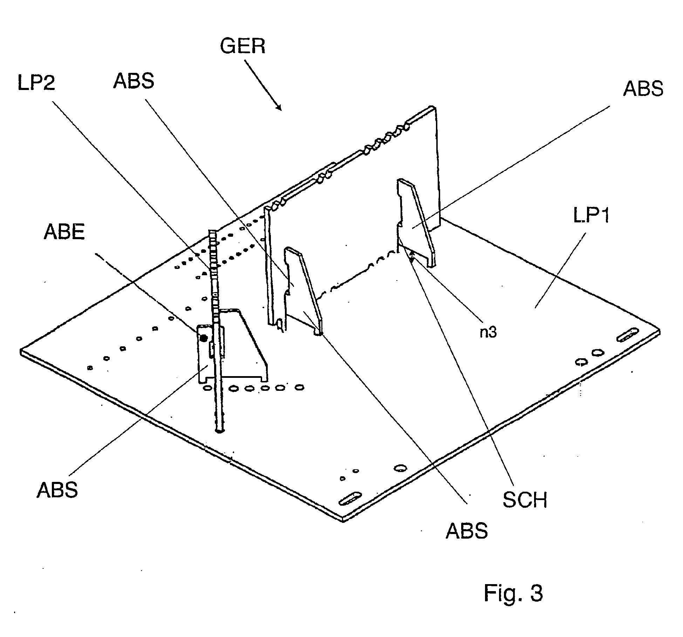

Gemäß Fig. 1 und 3 weist ein erfindungsgemäßes Abstützelement ABE eine Aufnahme AUF für eine auf einer Leiterplatte LP1, im Folgenden "Grundleiterplatte LP1" genannt, zu montierende Leiterplatte LP2, im weiteren Text als "Subleiterplatte LP2" bezeichnet, auf. Das Abstützelement ABE ist bevorzugterweise aus Metall gefertigt.

Die Aufnahme AUF wird von zwei Stegen ST1, ST2 mit je einem freien Ende EN1, EN2 begrenzt, wobei die Aufnahme AUF einen im wesentlichen U-förmigen Querschnitt aufweisen kann. Den freien Enden EN1, EN2 gegenüberliegende Abschnitte AB1, AB2 der Stege ST1, ST2 sind über den Grund GRU der Aufnahme AUF miteinander verbunden und voneinander beabstandet.

Weiters weisen die freien Enden EN1, EN2 der Stege ST1, ST2 in Richtung der Längsmittelebene λ der Aufnahme AUF vorspringende Fortsätze FO1, FO2 auf.

Der Normalabstand n1, n2 zwischen den Fortsätzen FO1, FO2 und der Längsmittelebene λ der Aufnahme AUF kann im Wesentlichen der halben Dicke der Subleiterplatte LP2 entsprechen. Darüber hinaus weisen die beiden Stege ST1, ST2 unterschiedliche Längen auf. Somit kann die Subleiterplatte LP2 in die Aufnahme AUF geschoben und von den zwischen ihr und den Stegen ST1, ST2 wirkenden Reibungskräften in ihrer Position gehalten werden.

Der Steg ST2 kann einen abgeschrägten Rücken RUE aufweisen, während der gegenüberliegende Steg ST1 eine im wesentlichen senkrecht zu der Leiterplatte LP1 verlaufenden Rücken RUE' aufweist. Durch die Abschrägung des Rückens RUE lässt sich die mechanische Stabilität der gestützten Subleiterplatte LP1 auf der Grundleiterplatte LP2 weiter erhöhen.

An die beiden Stege ST1, ST2 schließt sich ein Abschnitt ABS an, durch den die Aufnahme AUF von der Grundleiterplatte LP1 in einem montierten Zustand des Abstützelement beabstandet ist. An den Abschnitt ABS anschließend befinden sich zwei Befestigungsfortsätze BF1, BF2, die zur Verbindung mit der Grundleiterplatte LP1 vorgesehen sind. So können die Befestigungsfortsätze BF1, BF2 durch entsprechende Bohrungen in der Grundleiterplatte LP1 geführt und mit dieser verlötet werden.

An einander zugewandten Seiten der Befestigungsfortsätze BF1, BF2 können Vorsprünge VO1, V02 vorgesehen sein, die zur Abstützung an der Grundleiterplatte LP1 dienen. Damit wird zusätzlich die Grundleiterplatte LP1 von dem Abschnitt ABS des Abstützelementes ABE beabstandet, sodass auf der Grundleiterplatte LP1 angeordnete Leiterbahnen unter dem Abstützelement ABE durchlaufen können. Der Normalabstand zwischen der Grundleiterplatte LP1 und dem Abschnitt ABS des Abstützelementes ABE ist in Fig. 1 mit n3 bezeichnet.

Wie es aus Fig. 2 ersichtlich ist, weist das Abstützelement ABE eine im Wesentlichen plattenförmige Basis auf.

Nach Fig. 3 weist ein erfindungsgemäßes elektronisches Gerät GER zumindest zwei Leiterplatten LP1, LP2 auf, deren Leiterplattenebenen unter einem Winkel von im wesentlichen 90° zueinander verlaufen. Das Abstützelement ABE stützt die Subleiterplatten LP2 beim Löten und kann große mechanische Kräfte aufnehmen, welche zum Beispiel im Rahmen der Montage und des Betriebes auftreten können.

Die auf der Grundleiterplatte LP1 zu befestigenden Subleiterplatten LP2 weisen gemäß Fig. 3 einen Schlitz SCH für die Aufnahme des Abschnittes ABS des Abstützelementes ABE auf, wobei die Breite des Schlitzes SCH im Wesentlichen der Dicke d des Abstützelementes ABE entspricht. Somit umfasst die Subleiterplatte LP1 den Abschnittes ABS des Abstützelementes ABE seitlich. Dadurch wird die Stabilität der Subleiterplatten LP2 auf der Grundleiterplatte LP1 weiter erhöht.

Zusammenfassend lässt sich sagen, dass es die erfindungsgemäße Lösung ermöglicht, auf einfache und kostengünstige Weise, die Montage eines elektronischen Gerätes GER mit zumindest zwei Leiterplatten LP1, LP2 zu ermöglichen. Darüber hinaus lässt sich auch die mechanische Stabilität der montierten Leiterplatten LP1, LP2 wesentlich erhöhen.

## Patentansprüche

1. Abstützelement (ABE) für eine auf einer ersten Leiterplatte (LP1) angeordnete zweite Leiterplatte (LP2), wobei das Abstützelement (ABE) eine schlitzförmige Aufnahme (AUF) für die zweite Leiterplatte (LP2) und zumindest zwei Befestigungsfortsätze (BF1, BF2) aufweist, die zur Befestigung an der ersten Leiterplatte (LP1) vorgesehen sind und wobei die schlitzförmige Aufnahme (AUF) von zwei Stegen (ST1, ST2) mit je einem freien Enden (EN1, EN2) begrenzt ist, den freien Enden gegenüberliegende Abschnitte (AB1, AB2) der Stege (ST1, ST2) über den Grund (GRU) der Aufnahme (AUF) miteinander verbunden und voneinander beabstandet sind, **dadurch gekennzeichnet, dass** die freien Enden (EN1, EN2) in Richtung einer Längsmittelebene (λ) vorspringende Fortsätze (FO1, FO2) aufweisen und dass die freien Stege (ST1, ST2) unterschiedlich lang sind.

2. Abstützelement nach Anspruch 1, **dadurch gekennzeichnet, dass** zumindest ein Normalabstand (n1, n2) zwischen jedem Steg (ST1, ST2) und der Längsmittelebene (λ) der Aufnahme (AUF) im Wesentlichen der halben Dicke der zweiten Leiterplatte (LP2) entspricht.

3. Abstützelement nach einem der Ansprüche 1 bis 2, **dadurch gekennzeichnet, dass** es eine im Wesentlichen plattenförmige Basis aufweist.

4. Abstützelement nach einem der Ansprüche 1 bis 3, **dadurch gekennzeichnet, dass** die Aufnahme (AUF) einen im Wesentlichen U-förmigen Querschnitt aufweist.

5. Abstützelement nach einem der Ansprüche 1 bis 4, **dadurch gekennzeichnet, dass** es einen an die Aufnahme (AUF) anschließenden Abschnitt (ABS) aufweist, durch den die Aufnahme (AUF) in einem montierten Zustand von der ersten Leiterplatte (LP1) beabstandet ist.

6. Elektronisches Gerät (GER) mit zumindest zwei Leiterplatten (LP1, LP2), deren Leiterplattenebenen unter einem Winkel von im wesentlichen 90° zu einander verlaufen, **dadurch gekennzeichnet, dass** eine der beiden Leiterplatten (LP2) von einem Abstützelement (ABE) nach einem der Ansprüche 1 bis 5 gestützt und auf der anderen Leiterplatte (LP1) gehalten ist.

7. Elektronisches Gerät nach Anspruch 6, **dadurch gekennzeichnet, dass** die von dem Abstützelement (ABE) gestützte Leiterplatte (LP2) einen Schlitz (SCH) für den die Aufnahme (AUF) des Abstützelements (ABE) von der anderen Leiterplatte (LP1) beabstandenden Abschnitts (ABS) aufweist.

## Claims

1. Support element (ABE) for a second printed circuit board (LP2) arranged on a first printed circuit board (LP1), with the support element (ABE) having a slit-shaped recess (AUF) for the second printed circuit board (LP2) and at least two fastening appendages (BF1, BF2), which are provided to fasten to the first printed circuit board (LP1) and with the slit-shaped recess (AUF) being limited by two bars (ST1, ST2) each having a free end (EN1, EN2), the segments (AB1, AB2) of the bars (ST1, ST2) opposite the free ends being connected to one another by way of the base (GRU) of the recess and being distanced from one another, **characterised in that** the free ends (EN1, EN2) have appendages (FO1, FO2) projecting in the direction of a longitudinal midplane (λ) and that the free bars (ST1, ST2) have differing lengths.

2. Support element according to claim 1, **characterised in that** at least one normal distance (n1, n2) between each bar (ST1, ST2) and the longitudinal midplane (λ) of the recess (AUF) essentially corresponds to the half thickness of the second printed circuit board (LP2).

3. Support element according to one of claims 1 to 2, **characterised in that** it has an essentially plate-type base.

4. Support element according to one of claims 1 to 3, **characterised in that** the recess (AUF) has an essentially U-shaped cross-section.

5. Support element according to one of claims 1 to 4, **characterised in that** it has a segment (ABS) connecting to the recess (AUF), by means of which the recess (AUF) is at a distance from the first printed circuit board (LP1) in an assembled state.

6. Electronic device (GER) having at least two printed circuit boards (LP1, LP2), the printed circuit board planes of which run at an angle of essentially 90° to one another, **characterised in that** one of the two printed circuit boards (LP2) is supported by a support element (ABE) according to one of claims 1 to 5 and is held on other printed circuit board (LP1) .

7. Electronic device according to claim 6, **characterised in that** the printed circuit board (LP2) supported by the support element (ABE) has a slit (SCH) for the segment (ABS) distancing the recess (AUF) of the support element (ABE) from the other printed circuit (LP1).

## Revendications

1. Elément (ABE) de support d'une deuxième plaquette (LP2) à circuits imprimés disposée sur une première plaquette (Lp1) à circuits imprimés, l'élément (ABE) de support ayant un logement (AUF) en forme de fente pour la deuxième plaquette (LP2) à circuits imprimés et au moins deux prolongements de (BF1, BF2) de fixation, qui sont prévus pour la fixation sur la première plaquette (LP1) à circuits imprimés et le logement (AUF) en forme de fente étant délimité par deux barrettes (ST1, ST2) ayant respectivement une extrémité (EN1, EN2) libre, les parties (AB1, AB2) des barrettes (ST1, ST2) opposées aux extrémités libres étant reliées entre elles par le fond (GRU) du logement (AUF) et étant à distance l'une de l'autre, **caractérisé en ce que** les extrémités (EN1, EN2) libres, ont des prolongements (FO1, FO2) faisant saillie en direction d'un plan (λ) longitudinal médian et **en ce que** les barrettes (ST1, ST2) libres sont de longueurs différentes.

2. Elément de support suivant la revendication 1, **caractérisé en ce qu'**au moins une distance (n1, n2) normale entre chaque barrette (ST1, ST2) et le plan (λ) longitudinal médian du logement (AUF) correspond essentiellement à la moitié de l'épaisseur de la deuxième plaquette (LP2) à circuits imprimés.

3. Elément de support suivant l'une des revendications 1 à 2, **caractérisé en ce qu'**il a une base sensiblement en forme de plaque.

4. Elément de support suivant l'une des revendications 1 à 3, **caractérisé en ce** le logement (AUF) a une section transversale sensiblement en forme de U.

5. Elément de support suivant l'une des revendications 1 à 4, **caractérisé en ce qu'**il a une partie (ABS) qui se raccorde au logement (AUF) et par laquelle le logement (AUF) est, dans un état monté, à distance de la première plaquette (LP1) à circuits imprimés.

6. Appareil (GER) électronique ayant au moins deux plaquettes (LP1, LP2) à circuits imprimés, dont les plans font entre eux un angle de sensiblement 90°, **caractérisé en ce que** l'une des deux plaquettes (LP2) à circuits imprimés est supportée et maintenue sur l'autre plaquette (LP1) à circuits imprimés par un élément (ABE) de support suivant l'une des revendications 1 à 5

7. Appareil électronique suivant la revendication 6, **caractérisé en ce que** la plaquette (LP2) à circuits imprimés supportée par l'élément (ABE) de support a une fente pour la réception (AUF) de la partie (ABS) de l'élément (ABE) de support, qui est à distance de l'autre plaquette (LP1) à circuits imprimés.
